Europäisches Patentamt

European Patent Office

Office européen des brevets

(11) Veröffentlichungsnummer: **0 619 497 A1**

## (12) EUROPÄISCHE PATENTANMELDUNG

(21) Anmeldenummer: **94103705.3**

(22) Anmeldetag: **10.03.94**

(51) Int. Cl.5: **G01R 33/035**

(30) Priorität: **24.03.93 DE 4309293**

(43) Veröffentlichungstag der Anmeldung:
**12.10.94 Patentblatt 94/41**

(84) Benannte Vertragsstaaten:
**DE FR GB**

(71) Anmelder: **SIEMENS AKTIENGESELLSCHAFT**
**Wittelsbacherplatz 2**
**D-80333 München (DE)**

(72) Erfinder: **Daalmans, Gabriel M., Dipl.-Ing.**
**Ungarnstrasse 11**
**D-91056 Erlangen (DE)**
Erfinder: **Uhl, Dieter, Dipl.-Ing.**
**Sudetenstrasse 5**
**D-91080 Uttenreuth (DE)**

(54) **SOUID-Sensoreinrichtung mit einem Detektions- und einem Auslese-SOUID.**

(57) Die SQUID-Sensoreinrichtung (2) enthält ein DC-SQUID (7) sowie eine Elektronik (21) zur Verstärkung von mit dem SQUID (7) erzeugten Spannungssignalen. Erfindungsgemäß soll das SQUID (7) als ein Detektions-SQUID mit einer elektrischen Grundspannung (Spannungs-Bias) betrieben und Teil einer Serienschaltung mit einer Auskoppelspule (11) sein, über welche mit den Signalen des Detektions-SQUIDs (7) induktiv ein DC-Auslese-SQUID (15) anzusteuern ist, dessen Signale der nachgeordneten Elektronik (21) zuzuführen sind. Vorteilhaft kann sich ein an das Auslese-SQUID (15) direkt angeschlossener Vorverstärker (22) der Elektronik (21) auf Raumtemperatur befinden.

FIG 1

EP 0 619 497 A1

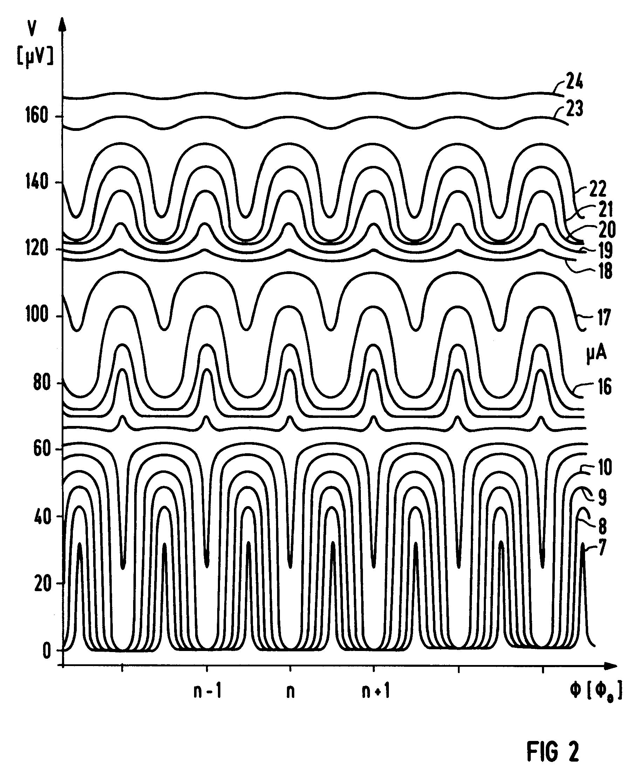

Die Erfindung bezieht sich auf eine SQUID-Sensoreinrichtung mit einem Gleichstrom-SQUID, in dessen SQUID-Schleife ein von einer zu detektierenden magnetischen Feldgröße abhängiger magnetischer Fluß hervorzurufen ist, und mit einer Elektronik zur Verstärkung von mit dem SQUID erzeugten, von dem magnetischen Fluß abhängigen Signalen. Eine derartige SQUID-Sensoreinrichtung ist prinzipiell aus der Veröffentlichung "IEEE Trans. Electron. Dev.", Vol. ED-27, No. 10, Okt. 1980, Seiten 1896 bis 1908 (vgl. insbesondere Fig. 2) bekannt.

Diese bekannte Sensoreinrichtung enthält ein insbesondere planares DC-SQUID (supraleitendes Gleichstrom-Quanten-Interferometer) mit zwei in eine SQUID-Schleife integrierten Josephson-Elementen. In diese Schleife wird induktiv mittels einer besonderen Einkoppelspule ein magnetischer Fluß eingekoppelt. Die Einkoppelspule ist dabei Teil eines auch als Flußtransformator bezeichneten Eingangskreises, der eine Antenne umfaßt, mit der eine magnetische Feldgröße detektiert wird und somit zu einem entsprechenden magnetischen Fluß führt. Über die z.B. einseitig auf Erdpotential gelegte SQUID-Schleife wird üblicherweise ein sogenannter Bias-Strom geführt, mit dessen Hilfe vorbestimmte Betriebszustände an den Josephson-Elementen eingestellt werden. An dem SQUID werden dann in Abhängigkeit von dem in seiner SQUID-Schleife induzierten magnetischen Fluß Spannungssignale erzeugt, die mittels einer nachgeordneten Elektronik verstärkt werden. Zur Anpassung dieser Elektronik an das SQUID und aus Gründen einer Begrenzung von Störsignalen ist das SQUID mit einer LC-Resonanzschaltung überbrückt, an deren Kondensator das SQUID-Spannungssignal abzunehmen ist. Diese Resonanzschaltung macht jedoch die SQUID-Sensoreinrichtung verhältnismäßig schmalbandig bezüglich des Frequenzbereiches, in dem das SQUID zu betreiben ist. Für eine Detektion von biomagnetischen Feldsignalen und bei einer Anwendung von Abschirmmaßnahmen spielt diese Schmalbandigkeit keine Rolle. Sie ist jedoch für breitbandige Verstärker unerwünscht.

Ferner wird eine Anpassung einer einem DC-SQUID nachgeordneten Elektronik auch durch eine Vergrößerung der Übertragungsfunktion des SQUIDs vorgenommen, indem man eine positive Rückkopplung vom Verstärker zum SQUID vorsieht. Eine derartige Technik ist aus dem Konferenzband der "Third International Superconductive Electronics Conference", 25.-27.6.1991, Glasgow (GB); Extendet Abstracts, Seiten 252 bis 259, bekannt. Bei diesen Maßnahmen führen jedoch Spannungsfluktuationen und Drifteffekte zu entsprechenden unerwünschten Magnetflußänderungen im SQUID. Außerdem ist der Rückkoppelfaktor abhängig vom Wert eines gewählten Bias-Stromes. Dann muß aber bei vorgegebenem Rückkoppelfaktor theoretisch nur ein einziger Bias-Punkt eingehalten werden. Dies ist jedoch für einen Dauerbetrieb kaum möglich.

Aufgabe der vorliegenden Erfindung ist es deshalb, eine DC-SQUID-Sensoreinrichtung mit den eingangs genannten Merkmalen anzugeben, die einen breitbandigen Betrieb ermöglicht, ohne daß die vorstehend erwähnten Probleme bei den bekannten, mit Strom-Bias betriebenen SQUID-Sensoreinrichtungen von Bedeutung sind. Dabei soll eine Anpassung des SQUIDs an einen Vorverstärker ohne Degradation des Signal-zu-Rausch-Verhältnisses zu gewährleisten sein.

Diese Aufgabe wird erfindungsgemäß dadurch gelöst, daß das SQUID als ein DC-Detektions-SQUID mit einer elektrischen Grundspannung (Spannungs-Bias) betrieben ist und daß dieses Detektions-SQUID Teil einer Serienschaltung mit einer Auskoppelspule ist, über welche mit den Signalen des Detektions-SQUIDs induktiv ein DC-Auslese-SQUID anzusteuern ist, dessen Signale der nachgeordneten Elektronik zuzuführen sind.

Die mit diesen Maßnahmen verbundenen Vorteile sind insbesondere darin zu sehen, daß bei der erfindungsgemäßen SQUID-Sensoreinrichtung eine erhebliche Anhebung des Signal- und Rausch-Niveaus ermöglicht wird. Damit kann dem Auslese-SQUID eine rauscharme Verstärkerelektronik nachgeordnet werden, die sich vorteilhaft auf Raumtemperatur befindet. Außerdem sind auch die Anforderungen an die Qualität des Auslese-SQUIDs um beispielsweise eine Größenordnung geringer als die an die Qualität des Detektions-SQUIDs.

Weitere vorteilhafte Ausgestaltungen der erfindungsgemäßen SQUID-Sensoreinrichtung gehen aus den abhängigen Ansprüchen hervor.

Die Erfindung wird nachfolgend anhand der Zeichnung noch weiter erläutert. Dabei zeigen

Figur 1    ein Prinzipsschaltbild einer erfindungsgemäßen SQUID-Sensoreinrichtung,
Figur 2    in einem Diagramm das an einer bekannten SQUID-Sensoreinrichtung mit Strom-Bias zu gewinnende Spannungssignal in Abhängigkeit vom magnetischen Fluß

und

Figur 3    in einem Diagramm das mit der erfindungsgemäßen SQUID-Sensoreinrichtung mit Spannungs-Bias zu gewinnende Stromsignal in Abhängigkeit vom magnetischen Fluß.

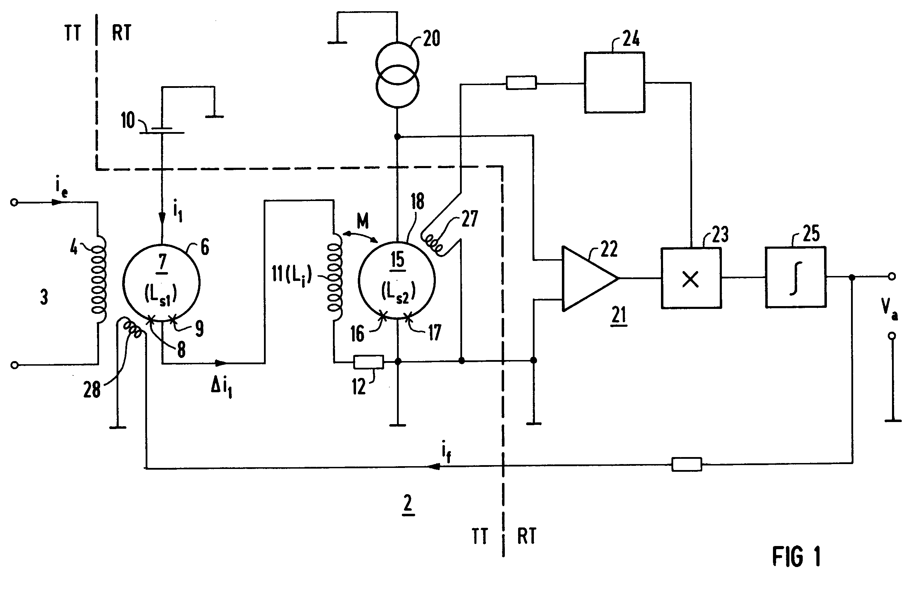

Bei der in Figur 1 angedeuteten Ersatzschaltung einer erfindungsgemäßen SQUID-Sensoreinrichtung wird von an sich bekannten Schaltungsteilen ausgegangen, wie sie für SQUID-Sensoren mit LHe-Kühltechnik und entsprechenden Supraleitermaterialien vorgesehen werden. Die allgemein mit 2 bezeichnete Einrichtung enthält einen nicht vollständig dargestellten Eingangskreis 3 mit einer supraleitenden Einkoppelspule 4. Bei dem Eingangskreis kann es sich beispielsweise um einen supraleitenden Flußtransformator handeln, der als Antenne zur Detektion einer magnetischen Feldgröße wie z.B. von Magnetfeldern oder von Magnetfeldgradienten ein Magnetometer bzw. Gradiometer bildet und einen Eingangsstrom $i_e$ führt. Mit der Einkoppelspule 4 wird ein entsprechender magnetischer Fluß induktiv in eine SQUID-Schleife 6 eines DC-SQUIDs 7 eingekoppelt. Dieses DC-SQUID stellt ein Detektions-SQUID mit zwei Josephson-Elementen 8 und 9 dar und wird statt mit einem elektrischen Grundstrom erfindungsgemäß mit einer elektrischen Grundspannung betrieben. Es ist so ein günstiger Arbeitsbereich des SQUIDs 7 auf Basis eines vorbestimmten, beispielsweise konstanten Spannungsniveaus einzustellen. Diese Betriebsweise wird auch als "Spannungs-Bias" bezeichnet. Hierzu ist das SQUID 7 auf das entsprechende elektrische Potential einer Spannungsquelle 10 gelegt. In Serie mit dem SQUID 7 ist eine Auskoppelspule 11 geschaltet, deren ein Ende über einen hinreichend kleinen Serienwiderstand 12 mit Erdpotential verbunden ist. Als Grundbedingung für den Spannungs-Bias muß der ohmsche Wert dieses Widerstands 12 bei einem durch die Serienschaltung fließenden Strom $i_1$ deutlich kleiner als der des SQUIDs sein. Gegebenenfalls kann auch der Serienwiderstand 12 weggelassen sein.

Zum Auslesen des an dem Detektions-SQUID 7 erzeugten Spannungssignals dient ein weiteres, nachfolgend als Auslese-SQUID 15 bezeichnetes DC-SQUID mit Josephson-Elementen 16 und 17. In die SQUID-Schleife 18 dieses SQUIDs 15 wird in an sich bekannter Weise das an dem Detektions-SQUID 7 erzeugte Signal induktiv über die Auskoppelspule 11 eingekoppelt. Das Auslese-SQUID 15 wird dabei in an sich bekannter Weise mit einem Strom-Bias betrieben. Ein hierfür erforderlicher Wechselstromgenerator ist mit 20 bezeichnet. Die Ausgangsspannung des Auslese-SQUIDs wird direkt, d.h. ohne besondere Anpassungsglieder, an eine nachgeordnete, allgemein mit 21 bezeichnete Elektronik, und zwar auf einen Vorverstärker 22, beispielsweise einen Operationsverstärker, gegeben. Dieser Vorverstärker kann sich vorteilhaft auf Raumtemperatur befinden. In der Figur ist der Übergang zwischen dem Tieftemperaturbereich TT mit den supraleitenden Teilen und dem Raumtemperaturbereich RT durch eine gestrichelte Linie angedeutet. Dem Vorverstärker 22 ist eine Mischerschaltung 23 nachgeordnet. In diese Mischerschaltung ist auch ein von einer Oszillatoreinrichtung 24 erzeugtes Signal eingespeist. Das so erhaltene Mischsignal wird dann über eine Integratorschaltung 25 als Ausgangssignal $V_a$ an eine nachgeordnete Elektronik zur weiteren Auswertung und Darstellung geleitet. Wie ferner aus dem gezeigten Schaltbild ersichtlich ist, erzeugt die Oszillatoreinrichtung 24 außerdem ein z.B. in die SQUID-Schleife 18 über eine Modulationsspule 27 induktiv einzukoppelndes Modulationssignal. Darüber hinaus kann durch eine Gegenkopplung z.B. bis zum Detektions-SQUID 7 die Gesamtschaltung linearisiert werden. Ein entsprechendes Gegenkopplungssignal mit einem Strom $i_f$ wird beispielsweise am Ausgang der Integratorschaltung 25 abgenommen und zu einer Gegenkopplungswicklung 28 an der Schleife 6 des Detektions-SQUIDs 7 geführt.

Nachfolgend sind Betriebsverhältnisse an einzelnen Teilen der erfindungsgemäßen SQUID-Sensoreinrichtung angedeutet:

Ein von einer externen Feldquelle in dem Eingangskreis 3 hervorgerufener magnetischer Fluß führt zu einem magnetischen Fluß $\phi_1$ in dem Detektions-SQUID 7. Dieser magnetische Fluß $\phi_1$ führt zu einem Ausgangsstromsignal $\Delta i_1$:

$$\Delta i_1 = \frac{\partial I_{c1}}{\partial \phi_1} * \phi_1$$

Dabei ist $I_{c1}$ der kritische Strom des SQUIDs 7.

Das Ausgangsstromsignal $\Delta i_1$ führt zu einem magnetischen Fluß $\phi_2$ in dem Auslese-SQUID 15 mit

$$\phi_2 = \Delta i_1 * M$$

M ist dabei die Gegeninduktivität zwischen der Auskoppelspule 11 und der SQUID-Schleife 18. Es gilt:

$$M = k * \sqrt{L_i * L_{s2}}$$

Dabei sind k die magnetische Koppelkonstante, $L_i$ die Induktivität der Auskoppelspule 11 und $L_{s2}$ die Induktivität der SQUID-Schleife 18 des Auslese-SQUIDs 15.

Für eine bekannte Ankopplung des Auslese-SQUIDs (nach Ketchen) gilt:

$$L_i = N^2 * L_{s2}$$

Dabei ist N die Wicklungszahl der Auskoppelspule 11.

Es ergibt sich dann:

$$\phi_2/\phi_1 = k * N * L_{s2} * \frac{\partial I_{c1}}{\partial \phi_1} = A_\phi$$

$A_\phi$ ist dabei die Flußverstärkung.

Für ein entsprechendes konkretes Ausführungsbeispiel seien ausgewählt:

$k = 0,9$

$N = 20$

$L_{s2} = 0,25 \text{ nH}$

$$\frac{\partial I_{c1}}{\partial \phi_1} = 12 \ \mu A/\phi_0$$

mit $\phi_0$ = Flußquant.

Dann ergibt sich

$$A_\phi = \frac{5 * 10^{-9} * 0,9 * 1,2 * 10^{-5}}{2 * 10^{-5}} = 27$$

Das Signal- und Rauschverhältnis des Detektions-SQUIDs wird also um einen Faktor 27 angehoben und liegt damit über dem Niveau von bekannten rauscharmen Vorverstärkern, die auf Raumtemperatur betrieben werden.

Mit der erfindungsgemäßen Ausgestaltung der SQUID-Sensoreinrichtung 2 sind noch weitere Vorteile verbunden:

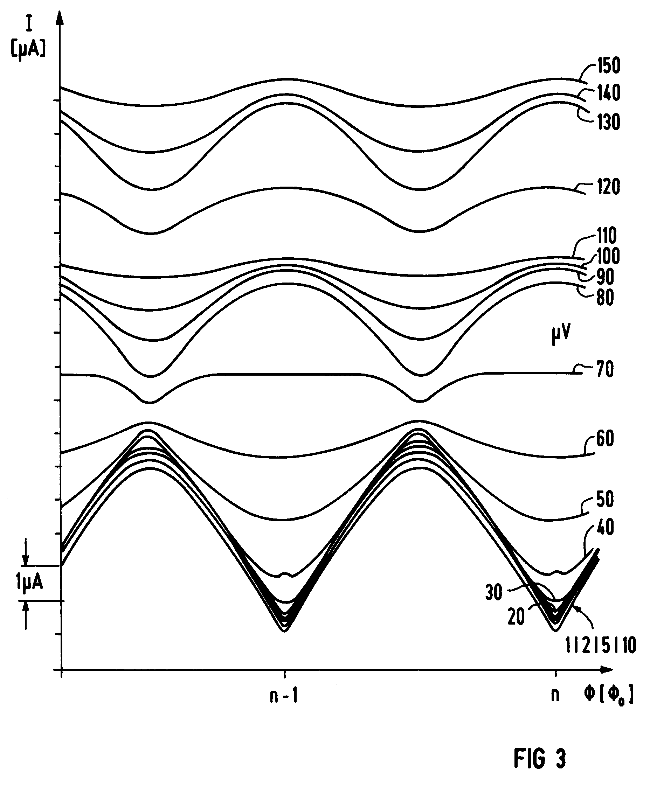

a) Das $I_c(\phi)$-Verhalten eines DC-SQUIDs mit Spannungs-Bias ist viel linearer als das eines SQUIDs mit Strom-Bias. Der entsprechende Sachverhalt ist bei einem Vergleich der Meßdiagramme der Figuren 2 und 3 erkennbar. Dabei zeigt das Diagramm der Figur 2 die an einem SQUID mit vorgegebenen Werten des Strom-Bias zu erhaltende Ausgangsspannung V (in $\mu$A) in Abhängigkeit von dem magnetischen Fluß $\phi$ (in Perioden der Flußquanten $\phi_0$). Die Strom-Bias-Werte (in $\mu$A) sind dabei an den einzelnen Kurven angegeben. Sieht man hingegen erfindungsgemäß einen Spannungs-Bias vor, so ergibt sich der aus dem Diagramm der Figur 3 entnehmbare Kurvenverlauf, wobei eine zu Figur 2 analoge Darstellung, jedoch mit größerem Abszissenmaßstab gewählt ist. Die Spannungs-Bias -Werte (in $\mu$V) sind an den einzelnen Kurven angegeben. Man erkennt, daß insbesondere für verhältnismäßig niedrige Bias-Spannungen zwischen 1 und 20 $\mu$V zwischen den einzelnen Flußquanten Gebiete hoher Linearität auftreten. Dies führt zu dem erheblichen Vorteil, daß die Lage der Arbeitspunkte des SQUIDs entsprechend unkritisch ist. Infolgedessen darf bei dem SQUID 7 mit Spannungs-Bias der Fluß-Bias weglaufen ohne erhebliche Änderung der Leistungsdaten des SQUIDs. Dies führt zu einer entsprechend hohen Dynamik der Betriebsweise.

b) Da der lineare Bereich bei dem SQUID mit Spannungs-Bias bei verhältnismäßig niedrigen Bias-Spannungen zwischen ungefähr 1 und 20 $\mu$V auftritt, kann der störende Einfluß von Resonanzen, die zu erhöhtem Rauschen führen, vermieden werden.

c) Die SQUID-Signale bei einem SQUID mit Spannungs-Bias sind ferner nur von der Größe

$$\beta_L = \frac{I_{c1} * L_{s1}}{\phi_0}$$

abhängig. Dabei sind $I_{c1}$ und $L_{s1}$ der kritische Strom bzw. die Induktivität des SQUIDs. Dann sind die Betriebsparameter für das SQUID relaxierter, d.h. in einem verhältnismäßig weiten Arbeitsbereich mit gutem SQUID-Verhalten unkritischer als bei einem SQUID mit Strom-Bias. Denn bei einem SQUID mit Spannungs-Bias ist das SQUID-Signal dann praktisch unabhängig von $\beta_L$, falls $\beta_L \geq 1$ ist. In diesem Bereich $\beta_L \geq 1$ ist der Signalwert maximal. Demgegenüber hängt bei einem SQUID mit Strom-Bias das Signal von $\beta_L$ und $I_c * R$ ab. Diese Abhängigkeit führt dazu, daß für Werte $\beta_L \geq 1$ das SQUID-Signal wieder zurückgeht. Deshalb sind bei dieser SQUID-Betriebsweise optimale Betriebsbedingungen entsprechend schwierig einzustellen sind. Außerdem ist auch die Abhängigkeit $I_c(\phi)$, bezogen auf $\beta_L$, beim SQUID mit Spannungs-Bias generell wesentlich geringer als die von $V(\phi)$ im Falle des SQUIDs mit Strom-Bias.

d) Da die Leistungsaufnahme des SQUIDs mit Spannungs-Bias gering gehalten werden kann, läßt sich auch die Rauschleistung entsprechend begrenzen und insbesondere nahe am thermischen Limit halten. Bei diesem thermischen Limit ist das Signal-zu-Rausch-Verhältnis eines spannungsgesteuerten SQUIDs gleich dem eines stromgesteuerten SQUIDs.

Gemäß dem Schaltbild nach Figur 1 wurde davon ausgegangen, daß bei der erfindungsgemäßen SQUID-Sensoreinrichtung ein von einer nicht-dargestellten Schleifenanordnung wie Magnetometer oder Gradiometer detektiertes Eingangssignal als Meßfluß induktiv in die SQUID-Schleife 6 des SQUIDs 7 eingekoppelt wird. Das SQUID kann jedoch auch integrierter Bestandteil der Schleifenanordnung sein (vgl. z.B. "IEEE Trans. Magn.", Vol. MAG-19; No. 3, Mai 1983, Seiten 648 bis 651).

Für die erfindungsgemäße SQUID-Sensoreinrichtung können deren supraleitende Teile aus den bekannten klassischen Supraleitermaterialien insbesondere in Form von Dünnfilmen hergestellt sein und mittels einer LHe-Technik auf ihrer supraleitenden Betriebstemperatur von z.B. 4,2 K gehalten werden. Ebensogut lassen sich jedoch bei der erfindungsgemäßen Sensoreinrichtung auch bekannte Hoch-$T_c$-Supraleitermaterialien einsetzen, die im allgemeinen mit einer $LN_2$-Technik z.B. auf einer Temperatur von 77 K, gegebenenfalls aber auch auf LHe-Temperatur zu halten sind. Beispiele entsprechender metalloxidischer Materialien basieren auf dem Stoffsystem Y-Ba-Cu-O, Bi-Sr-Ca-Cu-O oder Tl-Ba-Ca-Cu-O. Im Falle einer Verwendung solcher Hoch-$T_c$-Supraleitermaterialien kann der Serienwiderstand 12 gegebenenfalls auch normalleitend sein, sofern die Bedingungen für einen Spannungs-Bias eingehalten werden.

Darüber hinaus braucht das Spannungssignal der Spannungsquelle 10 für das DC-SQUID 7 mit Spannungs-Bias auch nicht unbedingt zeitlich konstant zu sein. Gegebenenfalls ist auch ein Bias mit einer alternierenden Spannung an dem SQUID möglich. Unter einem DC-SQUID einer erfindungsgemäßen SQUID-Sensoreinrichtung sei in diesem Falle ein entsprechendes Wechselspannungs-SQUID mit zwei Josephson-Elementen verstanden.

## Patentansprüche

1. SQUID-Sensoreinrichtung mit einem Gleichstrom(DC)-SQUID, in dessen SQUID-Schleife ein von einer zu detektierenden magnetischen Feldgröße abhängiger magnetischer Fluß hervorzurufen ist, und mit einer Elektronik zur Verstärkung von mit dem SQUID erzeugten, von dem magnetischen Fluß abhängigen Signalen, **dadurch gekennzeichnet, daß**

   - das SQUID (7) als ein DC-Detektions-SQUID mit einer elektrischen Grundspannung (Spannungs-Bias) betrieben ist

   und

   - dieses Detektions-SQUID (7) Teil einer Serienschaltung mit einer Auskoppelspule (11) ist, über welche mit den Signalen des Detektions-SQUIDs (7) induktiv in ein DC-Auslese-SQUID (15) anzusteuern ist, dessen Signale der nachgeordneten Elektronik (21) zuzuführen sind.

2. Sensoreinrichtung nach Anspruch 1, **dadurch gekennzeichnet,** daß das Auslese-SQUID (15) mit einem elektrischen Grundstrom (Strom-Bias) betrieben ist.

3. Sensoreinrichtung nach Anspruch 1 oder 2, **dadurch gekennzeichnet,** daß an das Auslese-SQUID (15) direkt ein Vorverstärker (22) der nachgeordneten Elektronik (21) angeschlossen ist.

4. Sensoreinrichtung nach einem der Ansprüche 1 bis 3, **dadurch gekennzeichnet,** daß eine auf das Auslese-SQUID (15) einwirkende Modulation vorgesehen ist.

5. Sensoreinrichtung nach einem der Ansprüche 1 bis 4, **dadurch gekennzeichnet** , daß eine Rückkopplung auf das Detektions-SQUID (7) vorgesehen ist.

6. Sensoreinrichtung nach einem der Ansprüche 1 bis 5, **dadurch gekennzeichnet,** daß die elektrische Grundspannung für das Detektions-SQUID (7) eine Konstantspannung ist.

7. Sensoreinrichtung nach einem der Ansprüche 1 bis 5, **dadurch gekennzeichnet,** daß die elektrische Grundspannung für das Detektions-SQUID (7) eine Wechselspannung ist.

8. Sensoreinrichtung nach einem der Ansprüche 1 bis 7, **dadurch gekennzeichnet,** daß für das Detektions-SQUID (7) eine elektrische Grundspannung zwischen 1 und 20 $\mu$V vorgesehen ist.

9. Sensoreinrichtung nach einem der Ansprüche 1 bis 8, **dadurch gekennzeichnet,** daß die SQUIDs (7, 15) mit metallischem Supraleitermaterial hergestellt sind.

10. Sensoreinrichtung nach einem der Ansprüche 1 bis 8, **dadurch gekennzeichnet,** daß die SQUIDs (7, 15) mit metalloxidischem Hoch-$T_c$-Supraleitermaterial hergestellt sind.

11. Sensoreinrichtung nach einem der Ansprüche 1 bis 10, **dadurch gekennzeichnet,** daß in der Serienschaltung ein Serienwiderstand (12) angeordnet ist.

12. Sensoreinrichtung nach einem der Ansprüche 1 bis 11, **dadurch gekennzeichnet,** daß ein dem Auslese-SQUID (15) nachgeordneter Vorverstärker (22) auf Raumtemperatur angeordnet ist.

FIG 1

EP 0 619 497 A1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| Y | SUPERCONDUCTOR SCIENCE AND TECHNOLOGY, Bd.4, Nr.9, September 1991, BRISTOL GB Seiten 377 - 385 D.DRUNG 'DC SQUID systems overwiew' * Seite 380, rechte Spalte, letzter Absatz - Seite 381, rechte Spalte, Absatz 2; Abbildungen 1,3 * --- | 1-12 | G01R33/035 |
| Y | EP-A-0 474 235 (DAIKIN IND.) * Zusammenfassung; Abbildung 1 * --- | 1-12 | |
| A | EP-A-0 212 452 (SIEMENS) * Spalte 6, Zeile 31 - Spalte 8, Zeile 8; Abbildung 4 * --- | 1 | |
| A | JAPANESE JOURNAL OF APPLIED PHYSICS, PART I, Bd.27, Nr.2, Februar 1988, TOKYO JP Seiten 214 - 218 S.KOHJIRO ET AL 'Conversion Efficiency of a Large-Beta DC SQUID with a Resistively Shunted Inductance' * das ganze Dokument * --- | 10 | RECHERCHIERTE SACHGEBIETE (Int.Cl.5) G01R |
| X | IEEE TRANSACTIONS ON MAGNETICS, Bd.23, Nr.2, März 1987, NEW YORK US Seiten 1662 - 1665 F.C.WELLSTOOD ET AL. 'Excess Noise in DC SQUIDs from 4.2K to 0.022K' * Seite 1662, rechte Spalte, Absatz 4 * --- | 1 | |

-/--

Der vorliegende Recherchenbericht wurde für alle Patentansprüche erstellt

| Recherchenort | Abschlußdatum der Recherche | Prüfer |
|---|---|---|
| BERLIN | 1. August 1994 | Fritz, S |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)

Europäisches Patentamt

**EUROPÄISCHER RECHERCHENBERICHT**

Nummer der Anmeldung

EP 94 10 3705

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | JAPANESE JOURNAL OF APPLIED PHYSICS, Bd.28, Nr.3, März 1989, TOKYO JP Seiten 456 - 458 H.FURUKAWA ET AL. 'Multichannel DC SQUID System' * Seite L457, rechte Spalte, Absatz 2 - Seite L458, rechte Spalte, Absatz 2; Abbildungen * | 1 | |
| X | PATENT ABSTRACTS OF JAPAN vol. 16, no. 551 (P-1453) 20. November 1992 & JP-A-04 208 886 (OSAKA GAS) 30. Juli 1992 * Zusammenfassung * | 1 | |

RECHERCHIERTE SACHGEBIETE (Int.Cl.5)

Der vorliegende Recherchenbericht wurde für alle Patentansprüche erstellt

| Recherchenort | Abschlußdatum der Recherche | Prüfer |
|---|---|---|
| BERLIN | 1. August 1994 | Fritz, S |

EPO FORM 1503 03.82 (P04C03)